# EUROPÄISCHE PATENTSCHRIFT

(11) **EP 0 463 227 B1**
(45) Veröffentlichungstag und Bekanntmachung des Hinweises auf die Patenterteilung: **15.03.1995**
(21) Anmeldenummer: 90122149.9
(22) Anmeldetag: 20.11.1990
(51) Int. Cl.: C23C 14/34, H01J 37/32

(54) **Katodenzerstäubungsvorrichtung**
Cathodic sputtering device
Dispositif de pulvérisation cathodique

(30) Priorität: 29.06.1990 DE 4020659
(43) Veröffentlichungstag der Anmeldung: 02.01.1992
(73) Patentinhaber: LEYBOLD AKTIENGESELLSCHAFT, D-63450 Hanau (DE)
(72) Erfinder: Zejda, Jaroslav, W-6458 Rodenbach 1 (DE)

(56) Entgegenhaltungen:
- EP-A- 0 291 690
- US-A- 4 169 031
- US-A- 4 564 435

## Beschreibung

Die Erfindung betrifft eine Katodenzerstäubungsvorrichtung mit Target, wie sie in der Vakuumbeschichtungstechnik eingesetzt werden, siehe hierzu beispielsweise den Prospekt 12-710.01 der Leybold AG "Copact Disks Vakuum-Beschichtungstechnik". Die Anwendung des Gegenstands der Erfindung ist jedoch nicht auf die Fälle, die in diesem Prospekt genannt werden, beschränkt.

Durch die Europäische Patentanmeldung 0291690 ist eine Vorrichtung zum Ein- und Ausschleusen eines im wesentlichen flachen Werkstücks in eine evakuierte Beschichtungskammer und zum Zuführen und Rückführen des Werkstücks in und aus dem Bereich einer Beschichtungsquelle zum Zwecke der Behandlung der Werkstückoberfläche bekannt geworden.

Der Gegenstand der genannten Europäischen Patentanmeldung ist gekennzeichnet durch eine im Bereich der Beschichtungskammer angeordnete Beschichtungsvorrichtung mit einem oder mehreren deckelförmigen Werkstückträgern, mit Hilfe derer die Werkstücke in eine einer Öffnung der Beschichtungskammer benachbarte Position bringbar sind, von der aus die Öffnung einerseits vom Werkstückträger und andererseits von einem Hubteller verschließbar ist, der auf einem innerhalb der Beschichtungskammer rotierbar gelagerten Drehteller gehalten und geführt ist,
wobei der Werkstückträger von einem sich an der Beschickungsvorrichtung abstützenden Hubzylinder an die Öffnung im Deckel der Beschichtungskammer und der Hubteller von einer an der Bodenplatte befestigten Hubvorrichtung anpressbar ist.

Bei Beschichtungsvorrichtungen der genannten Art sowie generell bei Katodenzerstäubungsvorrichtungen ist es notwendig, daß die Targets erneuert werden müssen, wozu die Targets üblicherweise an Teilen der Katodenkammer mit Schrauben oder Klemmstücken befestigt werden.

Um das Auswechseln der Targets zu vereinfachen, hat man deshalb bereits bei Rundkatoden vorgeschlagen (US-PS 4,564,435) das kreisringförmige Target mit Hilfe von im Grundkörper angeordneten Schrauben zu arretieren, wozu mehrere Schrauben in ein zentrales, sich axial erstreckendes flanschförmiges Teil des Grundkörpers so eingeschraubt sind, daß sie sich in radialer Richtung auf die radial innere Mantelfläche des Targets zu erstrecken und das Target am Grundkörper verspannen. Das Target ist dazu auf seiner dem Substrat abgewandten Seite fest mit einem Ring verbunden, dessen radial innere Zylinderfläche eine umlaufende V-Nut aufweist, in die die aus dem Flansch des Grundkörpers austretenden vorderen Enden der Schrauben einfassen.

Diese vorbekannte Target-Spannvorrichtung hat den Nachteil, daß das Auswechseln des Targets den vorherigen Ausbau eines Zentralkörpers voraussetzt, der fest mit dem Polschuh verschraubt ist, was naturgemäß längere Zeit in Anspruch nimmt und auch nicht ohne den Einsatz von Werkzeugen möglich ist.

Der Erfindung liegt die Aufgabe zugrunde:
Eine Schnellspannvorrichtung für Targets zu schaffen, die eine besonders einfache und schnelle Montage und Demontage von Targets ermöglicht.

Die gestellten Aufgaben werden durch eine Katodenzerstäubungsvorrichtung gemäß Anspruch 1 gelöst. Die Klemmvorrichtung besteht aus mindestens einem, vorzugsweise drei oder mehr, Wälzkörper-Pumpen-Mechanismen, die bei Relativbewegung mindestens einer Rampe zu mindestens einem Wälzkörper vorzugsweise einer Kugel, eine verklemmende Anpreßkraft auf das Targetaggregat ausübt.

Weitere Einzelheiten und Merkmale der Erfindung sind in den Unteransprüchen näher beschrieben und gekennzeichnet.

Ein Ausführungsbeispiel wird anhand von fünf Figuren erläutert.
Figur 1 zeigt in einer Schnittdarstellung das Katodenkammeroberteil des Ausführungsbeispiels.
Die Figur 2 bis 4 zeigen die Spannhülse des Ausführungsbeispiels
Figur 5 zeigt die Maske der Katodenstation des Ausführungsbeispiels.

Bei der nachfolgenden Beschreibung des Ausführungsbeispiels der Erfindung wird von einem Stand der Technik ausgegangen, wie er sich in Form der oben zitierten Schriften darstellt.

Die Beschreibungen und die Figuren dieser Schriften können zur Erläuterung der Ausgangsbasis für das nachfolgend beschriebene Ausführungsbeispiel der Erfindung herangezogen werden.

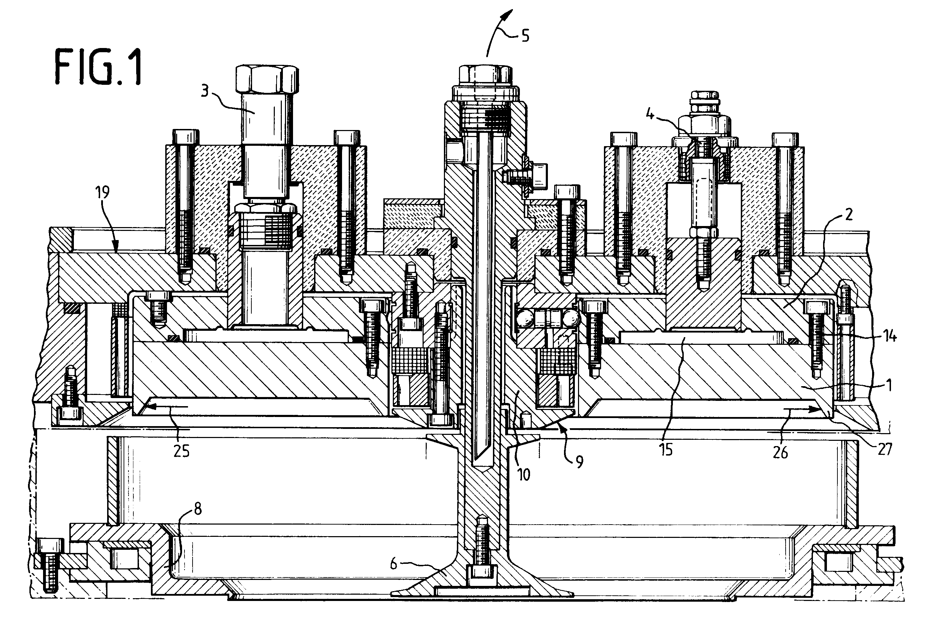

Figur 1 zeigt ein Katodenkammeroberteil 19, das ein ringförmiges Targetaggregat beherbergt. Das Targetaggregat besteht aus dem Target 1 und der Targetgrundplatte 2. Target und Grundplatte sind durch Schraubenbolzen, von denen einer mit 14 bezeichnet ist, miteinander verbunden. Zwischen Target und Targetgrundplatte wird ein Wasserkühlraum 15 gebildet.

Mit 3 ist die Schnellkupplung für die Kühlwasserversorgung bezeichnet. 4 ist die Schnellkupplung für den elektrischen Stromanschluss.

Das Targetaggregat ist zusammen mit dem Katodenkammeroberteil von der Katodenkammer in Richtung des Pfeils 5 von den übrigen Teilen der Katodenstation abschwenkbar. Die Schnellkupplung für die Kühlwasserversorgung und diejenige für den elektrischen Stromanschluss sind um 180 Grad versetzt auf dem Oberteil angeordnet.

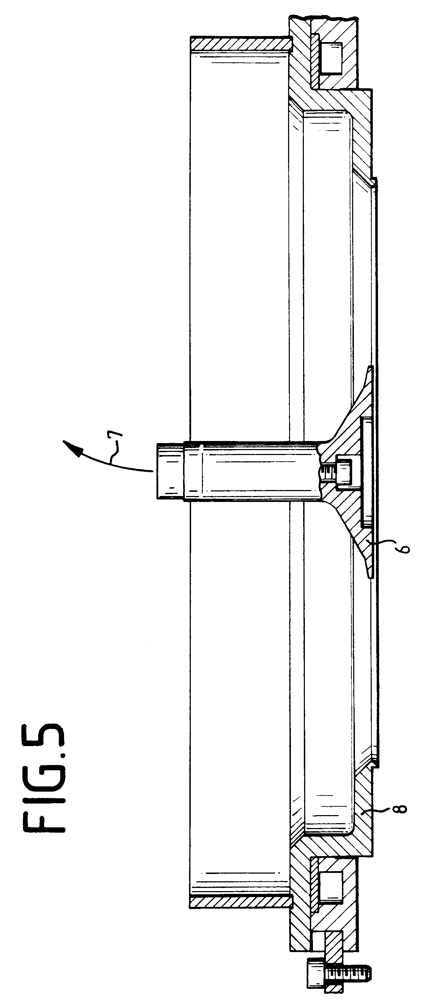

Mit der Unterseite des Katodenoberteils verbunden ist der zentrale Teil 6 der zweiteiligen Maske der Katodenstation, siehe hierzu auch Figur 5. Bei einem Verschwenken des Katodenoberteils bewegt sich daher auch der zentrale Maskenteil 6 in der Schwenkrichtung gemäß Pfeil 7 (Figur 5) vom stationären Maskenteil 8 fort. In Figur 5 ist die Maske in Arbeitsposition dargestellt. Sie dient zur Konzentration des Plasmas auf das nicht dargestellte Substrat während des Sputtervorgangs, siehe hierzu den oben genannten Stand der Technik.

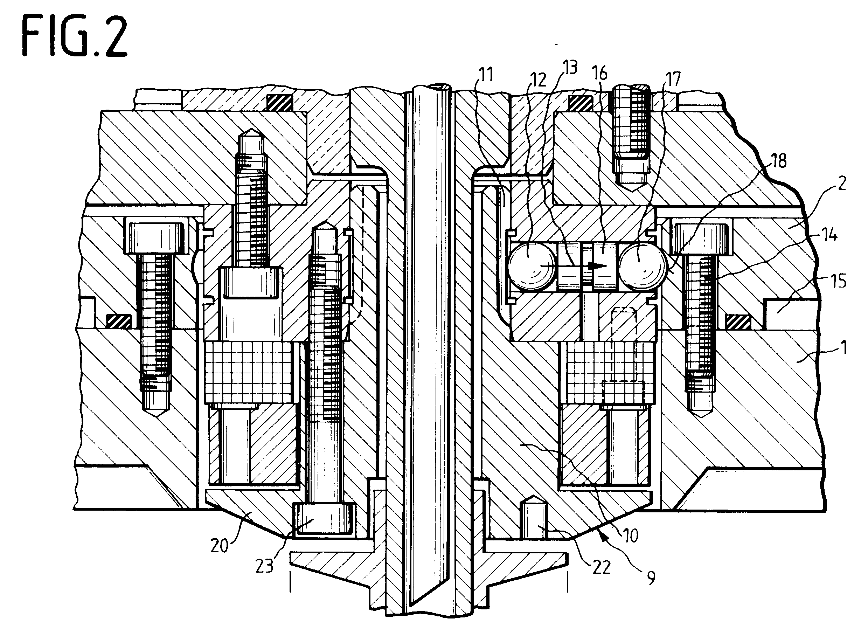

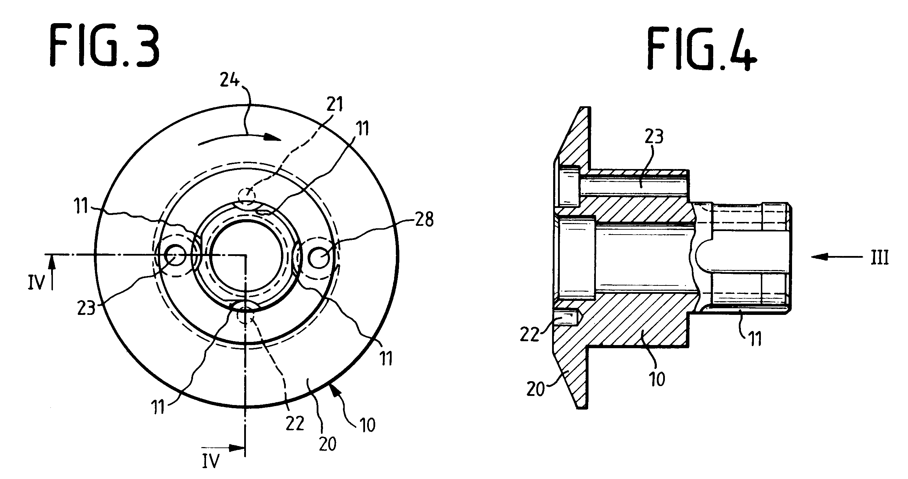

Mit 9 ist eine Klemmvorrichtung in ihrer Gesamtheit bezeichnet, sie besteht, siehe hierzu die Figuren 2 bis 4, aus einer Spannhülse 10, die im Bereich ihrer äußeren Mantelfläche Ausfräsungen 11 aufweist, siehe Figur 3.

Figur 2 ist eine vergrößerte Darstellung des zentralen Bereichs des Gegenstands der Figur 1. Figur 3 zeigt die Spannhülse in einer Ansicht gemäß Pfeil III der Figur 4. Figur 4 ist eine Schnittdarstellung entsprechend der Schnittlinie IV-IV der Figur 3.

Aus Figur 3 geht hervor, daß insgesamt vier Ausfräsungen 11 vorgesehen sind.

Wenn die Spannhülse um cirka 45 Grad gegenüber dem in Bezug auf die Spannhülse stationär anzusehenden Katodenkammeroberteil verdreht wird, pressen die als Rampen wirkenden Ausfräsungen 11 vier Kugeln, von denen nur eine in Figur 2 zeichnerisch dargestellt ist und das Bezugszeichen 12 trägt, radial nach außen in Richtung des Pfeils 13.

Die Kugeln 12 verschieben dabei vier Distanzstücke, von denen eines in Figur 2 dargestellt und mit 16 bezeichnet ist, ebenfalls radial nach außen. Die Distanzstücke wiederum verschieben vier Kugeln 17, in eine ausgefräste Nut 18 in der äußeren Mantelfläche der Targetgrundplatte 2.

Durch dieses Verdrehen wirkt die Spannhülse als Sperriegel, der das Targetaggregat in seiner Arbeitsposition durch Verklemmung arretiert und zentriert.

Es folgt eine Beschreibung des Auswechselns des Targetaggregats:
Das Katodenoberteil, das auch als Deckel bezeichnet wird, und in seiner Gesamtheit die Bezugsziffer 19 trägt, wird in Richtung des Pfeils 5 um 180 Grad aus der in Figur 1 dargestellten ersten Position, Sputterposition, in eine zweite, horizontale Position, Wartungsposition, verschwenkt. In dieser zweiten Position sind das Target und das pilzförmige Endteil 20 der Spannhülse, sowie alle anderen Teile, die mit der Unterseite des ausschwenkbaren Deckels der Katodenstation verbunden sind, in Bezug auf den Betrachter offen und einfach zugänglich.

Mit einem Spezialwerkzeug in Form eines Stiftschlüssels wird nach Lösen der Sicherungsschraube 23 in die Sacklöcher 21, 22 eingegriffen. Die Spannhülse wird mit dem Werkzeug um cirka 45 Grad verdreht und zwar in Richtung des Pfeils 24, Figur 3.

Hierdurch werden die Kugeln 12, die Distanzstücke 16 und die Kugeln 17 frei gegeben. Die Verklemmung des Targetaggregats wird aufgehoben.

Mit einer Abzugsvorrichtung, deren spitze Greiforgane zunächst radial in Richtung der Pfeile 25, 26 gegen den Rand 27 des Targets gedrückt werden, wird das Targetaggregat erfasst und anschließend axial nach oben aus dem Deckel der Katodenstation entnommen. Dabei wird der Wasseranschluss 3 entkuppelt und verschlossen. Ebenso wird der Stromanschluss 4 unterbrochen. Die Organe 3 und 4 sind an sich bekannte Schnellkupplungen für Wasser, beziehungsweise Strom.

Der Einbau eines neuen Targetaggregats erfolgt im wesentlichen in umgekehrter Reihenfolge:
Das Targetaggregat wird in axialer Richtung in den Deckel der Katodenkammer eingesetzt. Die Kupplungsorgane für die Wasser- und Stromanschlüsse werden verbunden. Die als Sperrhülse dienende Spannhülse 10 wird um cirka 45 Grad entgegen der Richtung des Pfeils 24 verdreht. Dadurch werden die vier Kugeln 12 durch die Rampen 11 in Richtung des Pfeils 13 radial nach außen gedrückt. Wie oben beschrieben, werden hierdurch die Kugeln 12, die Distanzstücke 16 und die Kugeln 17 zwischen der Targetgrundplatte und der Spannhülse verklemmt. Die Sicherungsschrauben 23, 28 werden eingeschraubt. In den Figuren 3 und 4 sind zum einfacheren Verständnis die Bohrungen für die Sicherungsschrauben 23, 28 ebenfalls mit 23, 28 bezeichnet.

In vorteilhafter Weise kann also durch einen Handgriff das Targetaggregat gelöst oder gespannt werden.

Die Kugeln sind aus hartem und isolierendem Material hergestellt. Insbesondere ist hierzu Al₂O₃ vorgesehen. Die isolierende Eigenschaft ist deshalb notwendig, da funktionsbedingt zwischen dem Targetaggregat und dem Deckel der Katodenzerstäubungsvorrichtung ein Spannungsunterschied besteht.

Bei Kleinkatoden kann vorgesehen werden, daß die Distanzstücke entfallen und zwei Kugeln oder auch nur eine Kugel zwischen der Spannhülse und der Targetgrundplatte verklemmt werden.

## Patentansprüche

1. Katodenzerstäubungsvorrichtung mit einem den Stromanschluß (4) und den Kühlwasserversorgungsanschluß (3) aufnehmenden Katodenoberteil (19), einem von diesem gehaltenen kreisringförmigen Targetaggregat (1, 2), bestehend aus einer Targetgrundplatte (2) und einem mit dieser fest verbundenen kreisringförmigen Target (1) aus dem zu zerstäubenden Material, und einer von innen aus in radialer Richtung auf die Targetgrundplatte (2) einwirkenden Klemmvorrichtung für den raschen Austausch des Targetaggregats (1, 2), **dadurch gekennzeichnet**, daß die Klemmvorrichtung aus mindestens einem, vorzugsweise drei oder mehr, Wälzkörper-Rampen-Mechanismen besteht, die bei Relativbewegung mindestens einer Rampe (11) zu mindestens einem Wälzkörper, vorzugsweise einer Kugel (12), eine verklemmende Anpresskraft auf das Targetaggregat ausübt.

2. Katodenzerstäubungsvorrichtung nach Anspruch 1, **dadurch gekennzeichnet**, daß die Klemmvorrichtung (9) eine verdrehbare mit mindestens einer, vorzugsweise mit mehreren Rampen (11) für die Wälzkörper (12) versehene Spannhülse (10) aufweist, die beim Verdrehen mittels ihrer Rampen die Wälzkörper mittel- oder unmittelbar gegen das Targetaggregat (1, 2) preßt.

3. Katodenzerstäubungsvorrichtung nach Anspruch 2, **dadurch gekennzeichnet**, daß die Spannhülse (10) zentral zum ringförmigen Targetaggregat (1, 2) angeordnet ist und der Wälzkörper-Rampen-Mechanismus das Targetaggregat durch radial nach außen gerichtete Kräfte verklemmt und fixiert.

4. Katodenzerstäubungsvorrichtung nach den Ansprüchen 2 und 3, **dadurch gekennzeichnet**, daß die Spannhülse (10) als Sperriegel ausgebildet ist, der um ein bestimmtes Maß um die Achse des Targetaggregats (1, 2) verdreht werden kann und dabei die Wälzkörper, insbesondere Kugeln (12), nach außen drückt und damit das Targetaggregat durch Verklemmung in seiner Arbeitsposition verriegelt.

5. Katodenzerstäubungsvorrichtung nach den Ansprüchen 2 bis 4, **dadurch gekennzeichnet**, daß die Rampen (11) als exzentrische Ausfräsungen auf Teilen der äußeren Mantelfläche der Spannhülse (10) ausgebildet sind.

6. Katodenzerstäubungsvorrichtung nach den Ansprüchen 2 bis 5, **dadurch gekennzeichnet**, daß einer Rampe (11) zwei Kugeln (12, 17), die durch ein Distanzstück (16) getrennt sind, zugeordnet sind, die zwischen Spannhülsen (10) und Targetaggregat (1, 2) verklemmt werden.

7. Katodenzerstäubungsvorrichtung nach Anspruch 1, **dadurch gekennzeichnet**, daß die Klemmvorrichtung (9) im Katodenkammeroberteil (19), das zum Auswechseln des Targetaggregats (1, 2) von der Katodenkammer entfernbar, insbesondere schwenkbar, angeordnet und ausgebildet ist, untergebracht ist, so daß im entfernten, insbesondere ausgeschwenkten Zustand des Katodenkammeroberteils, das Targetaggregat (1, 2) durch Lösen der Klemmvorrichtung (9) leicht ausbaubar ist.

8. Katodenzerstäubungsvorrichtung nach den Ansprüchen 1 und 7, **dadurch gekennzeichnet**, daß am Katodenkammeroberteil (19), das zum Auswechseln des Targetaggregats (1, 2) von der Katodenkammer entfernbar, insbesondere schwenkbar, angeordnet und ausgebildet ist, ein zentraler Teil (6) einer zweiteiligen Maske (6, 8) der Katodenstation angebracht ist, der mit dem Katodenoberteil von der Katodenkammer entfernbar, insbesondere schwenkbar ist, während der äußere, ringförmige Randteil (8) des Maske in seiner Arbeitsposition bleibt.

9. Katodenzerstäubungsvorrichtung nach Anspruch 2 und 6, **dadurch gekennzeichnet**, daß die Wälzkörper (12, 17), insbesondere die Kugeln, aus isolierendem Material, insbesondere aus Al₂O₃ bestehen.

## Claims

1. Cathode sputtering device with a cathode chamber upper part (19) which includes the power-supply connection (4) and the cooling-water supply connection (3), an annular target assembly (1, 2), contained within the cathode chamber upper part, comprised of a target base plate (2) and an annular target (1), fixed to the latter, composed of the material which is to be sputter-treated, and a clamping device, acting radially on the target base plate (2) from the inside to the outside, for rapid changing of the target assembly (1, 2), **characterized in that** the clamping device is comprised of one or more, preferably three of more, rolling element ramp mechanisms which exert a binding contact force on the target assembly through movement of one or more ramps (11) relative to one or more rolling elements, preferably a ball (12).

2. Cathode sputtering device according to Claim 1, **characterized in that** the clamping device (9) possesses a torsible clamping sleeve (10) having one or more, preferably several, ramps (11) for the rolling elements (12), which presses the rolling elements against the target assembly (1, 2), either directly or indirectly, by means of its ramps when it is twisted.

3. Cathode sputtering device according to Claim 2, **characterized in that** the clamping sleeve (10) is located in the centre of the annular target assembly (1, 2) and the rolling element ramp mechanism clamps and fixes the target assembly through forces directed radially outwards.

4. Cathode sputtering device according to either of Claims 2 or 3, **characterized in that** the clamping sleeve (10) is constructed as a clamping bolt which can be twisted by a defined amount around the axis of the target assembly (1, 2), pressing the rolling elements, particularly balls (12), outwards and thereby locking the target assembly by clamping it in its operating position.

5. Cathode sputtering device according to any one of Claims 2 to 4, **characterized in that** the ramps (11) are formed as eccentric recesses on parts of the outer circumferential surface of the clamping sleeve (10).

6. Cathode sputtering device according to any one of Claims 2 to 5, **characterized in that** two balls (12, 17), separated by a distance-piece (16), are assigned to one ramp (11), the balls being clamped between the clamping sleeve (10) and the target assembly (1, 2).

7. Cathode sputtering device according to Claim 1, **characterized in that** the clamping device (9) is housed within the cathode chamber upper part (19) which is disposed and constructed so that it can be removed, particularly by swivelling, from the cathode chamber for the purpose of changing the target assembly (1, 2) so that, when the cathode chamber upper part has been removed, particularly by swivelling, the target assembly (1, 2) is easily removable by releasing the clamping device (9).

8. Cathode sputtering device according to either of Claims 1 or 7, **characterized in that** there is mounted on the cathode chamber upper part (19) which is disposed and constructed so that it can be removed, particularly by swivelling, from the cathode chamber for the purpose of changing the target assembly (1, 2), a central part (6) of a two-part mask (6, 8) of the cathode station which is removable, particularly by swivelling, from the cathode chamber, together with the cathode chamber upper part, while the outer annular edge part (8) of the mask remains in its operating position.

9. Cathode sputtering device according to either of Claims 2 or 6, **characterized in that** the rolling elements (12, 17), particularly the balls, are composed of an insulating material, particularly Al₂O₃.

## Revendications

1. Dispositif de pulvérisation cathodique comprenant une partie supérieure de cathode (19) accueillant le raccordement de courant (4) et le raccordement de fourniture d'eau de refroidissement (3), un ensemble de cible (1, 2) en forme d'anneau cylindrique maintenu par celle-ci, consistant en une plaque de base de cible (2) et une cible (1) en forme d'anneau cylindrique, reliée fixe avec celle-ci, constituée du matériau à pulvériser, et un dispositif de serrage agissant à partir de l'intérieur, en direction axiale, sur la plaque de base de cible (2), pour l'échange rapide de l'ensemble de cible (1, 2), caractérisé en ce que le dispositif de serrage consiste au moins en un, de façon préférée trois ou plus, mécanisme(s) de corps de rouleau et de rampe, qui, lors de mouvement relatif d'au moins une rampe (11), à au moins un corps de rouleau, de façon préférée à une bille (12), exerce une force de pression coinçante sur l'ensemble de cibles.

2. Dispositif de pulvérisation cathodique selon la revendication 1, caractérisé en ce que le dispositif de serrage (9) présente un manchon de contrainte (10) susceptible d'être tourné, pourvu d'au moins une rampe (11), de façon préférée de plusieurs rampes, pour les corps de rouleaux (12), qui, lors de la rotation, presse, au moyen de ses rampes, les corps de rouleau indirectement ou directement contre l'ensemble de cible (1, 2).

3. Dispositif de pulvérisation cathodique selon la revendication 2, caractérisé en ce que le manchon de contrainte (10) est agencé centralement à l'ensemble de cible (1, 2) en forme d'anneau et que le mécanisme à corps de rouleau et rampes coince et fixe l'ensemble de cible par des forces dirigées radialement vers l'extérieur.

4. Dispositif de pulvérisation cathodique selon la revendication 2 et la revendication 3, caractérisé en ce que le manchon de contrainte (10) est constitué comme verrou d'arrêt, qui, dans une certaine mesure, peut être tourné autour de l'axe de l'ensemble de cible (1, 2) et, par ailleurs, presse les corps de rouleau, en particulier des billes (12), vers l'extérieur et, par suite, verrouille l'ensemble de cible, par coincement, dans sa position de travail.

5. Dispositif de pulvérisation cathodique selon les revendications 2 à 4, caractérisé en ce que les rampes (11) sont constituées, comme des fraisages excentriques, sur des parties de la face d'enveloppe extérieure du manchon de contrainte (10).

6. Dispositif de pulvérisation cathodique selon les revendications 2 à 5, caractérisé en ce qu'à une rampe (11), sont associées deux billes (12, 17), qui sont séparées par une pièce intercalaire (16), qui sont coincées entre le manchon de contrainte (10) et l'ensemble de cible (1, 2).

7. Dispositif de pulvérisation cathodique selon la revendication 1, caractérisé en ce que le dispositif de serrage (9) est logé dans la partie supérieure de chambre de cathode (19), qui, pour l'échange de l'ensemble de cibles (1, 2), est agencée et constituée susceptible d'être éloignée de la chambre de cathode, en particulier susceptible d'être pivotée, de sorte que, dans l'état éloigné, en particulier pivoté vers l'extérieur, de la partie supérieure de chambre de cathode, l'ensemble de cible (1, 2) est facilement démontable par desserrage du dispositif de serrage (9).

8. Dispositif de pulvérisation cathodique selon les revendications 1 et 7, caractérisé en ce qu'à la partie supérieure de chambre de cathode (19), qui, pour l'échange de l'ensemble de cibles (1, 2), est agencée et constituée susceptible d'être éloignée de la chambre de cathode, en particulier susceptible d'être pivotée, est adjointe une partie (6) centrale d'un masque (6, 8) en deux parties du poste de cathode, qui, avec la partie supérieure de cathode, est susceptible d'être éloignée de la chambre de cathode, en particulier est susceptible d'être pivotée, tandis que la partie de bord (8) extérieure, en forme d'anneau, du masque reste dans sa position de travail.

9. Dispositif de pulvérisation cathodique selon la revendication 2 et la revendication 6, caractérisé en ce que les corps de rouleau (12, 17), en particulier les billes, consistent en un matériau isolant, en particulier du Al₂O₃.
